Europäisches Patentamt

European Patent Office

Office européen des brevets

(19)

(11) Veröffentlichungsnummer: **0 269 889**

A1

(12) **EUROPÄISCHE PATENTANMELDUNG**

(21) Anmeldenummer: 87116153.5

(22) Anmeldetag: 03.11.87

(51) Int. Cl.⁴: **B07C 5/344** , B07C 5/36

(30) Priorität: 11.11.86 DE 3638431

(43) Veröffentlichungstag der Anmeldung:
08.06.88 Patentblatt 88/23

(84) Benannte Vertragsstaaten:
AT BE CH DE FR GB IT LI LU NL SE

(71) Anmelder: Multitest Elektronische Systeme
GmbH
Arnulfstrasse 13
D-8200 Rosenheim-Aisingerwies(DE)

(72) Erfinder: Müller, Christian
Arnulfstrasse 53
D-8200 Rosenheim(DE)

(74) Vertreter: Schmidt-Evers, Jürgen, Dipl.-Ing. et
al
Patentanwälte Dipl.-Ing. H. Mitscherlich
Dipl.-Ing. K. Gunschmann Dipl.-Ing.
Dr.rer.nat. W. Körber Dipl.-Ing. J.
Schmidt-Evers Dipl.-Ing. W. Melzer
Steinsdorfstrasse 10
D-8000 München 22(DE)

(54) Einrichtung zum Testen und Sortieren von elektronischen Bauelementen, insbesondere von dual-in-line-IC's.

(57) Bei einer Einrichtung zum Testen und zum Sortieren von elektronischen Bauelementen, insbesondere von dual-inelektronischen Bauelementen, insbesondere von dual-in-line-IC's ist der Vereinzelungsvorrichtung (8) ein Transportrad (28, 29) nachgeschaltet. Dieses weist an seiner Peripherie (6) Aufnahmekäfige (31) für die Bauelemente (4) auf. Bei dem intermetierendem Drehbetrieb des Transportrades können alle Aufnahmekäfige eine Ladestation (A), eine Teststation (B) und eine Entladestation (C) durchlaufen. In der Teststation (B) ist der betreffende Aufnahmekäfig radial nach außen verschiebbar, wodurch die Anschlußkontakte des Bauelementes in Kontakt mit einem Testadapter (43) gebracht werden. Die Vereinzelungsvorrichtung (8) vereinzelt die aufeinanderfolgend anlaufenden Bauelemente (4) durch Abscheeren und Drehen, wobei gleichzeitig ein Wenden der Bauelemente (4) erfolgt.

EP 0 269 889 A1

FIG. 1

# Einrichtung zum Testen und Sortieren von elektronischen Bauelementen, insbesondere von dual-in-line-IC's

Die Erfindung betrifft eine Einrichtung zum Testen und Sortieren von elektronischen Bauelementen, insbesondere von dual-in-line-IC's, mit einem Eingangsmagazin, das mindestens einen Magazinkanal für die zu testenden Bauelemente aufweist, mit einer Vereinzelungsvorrichtung für die dem Magazinkanal nacheinander zu entnehmenden Bauelemente, mit einer Teststation, in welcher die zu prüfenden Bauelemente in Kontakt mit einem Prüfadapter gebracht werden, dem von einem Testcomputer Testsignale zugeführt werden, mit einem Ausgangsmagazin, das mindestens einen Magazinkanal für die als gut befundenen Bauelemente und mindestens einen Magazinkanal für die als schlecht oder fehlerhaft befundenen Bauelemente aufweist.

Eine derartige Einrichtung ist nach der DE-OS 33 40 183 bekannt. Bei dieser bekannten Einrichtung weist das Eingangsmagazin eine Vielzahl von Magazinkanälen auf. Es ist quer zur Längsrichtung der Magazinkanäle verfahrbar, wodurch der Ausgang der einzelnen Magazinkanäle nacheinander vor die Vereinzelungsvorrichtung gefahren werden kann. Die feststehende Vereinzelungsvorrichtung besteht aus einem über einer Gleitbahn angeordneten Bandförderer mit Lichtschranke. Die vereinzelten Bauelemente fallen durch senkrechten Testkanal bis zu Teststation. Dort werden Federfinger eines mit dem Testcomputer verbundenen Testadapters in Kontakt mit den Anschlüssen des Bauelementes gebracht. Nach dem Testvorgang fällt das getestete Bauelement in dem Prüfkanal weiter abwärts bis zu einem Sortiershuttle, welches quer zu den Magazinkanälen eines feststehenden Ausgangsmagazines verfahrbar ist. Das Sortiershuttle befördert die getesteten Bauelemente zum Eingang desjenigen Magazinkanals der durch das Testergebnis bestimmt wird.

Es hat sich herausgestellt, daß die Federfinger des Testadapters zur Übertragung von hohen Frequenzen ungünstig sind. Der Erfindung liegt deshalb die Aufgabe zugrunde, eine Möglichkeit zu -schaffen, um eine hochfrequenzmäßig günstigere Ankopplung der Bauelemente an den Testadapter zu erhalten.

Die Aufgabe ist erfindungsgemäßen gelöst durch ein intermetierend drehbares Transportrad, das mindestens an drei Stellen seines Umfangs einen Aufnahmekäfig mit einem etwa tangential verlaufenden Aufnahmekanal für ein Bauelement aufweist, der so ausgebildet ist, daß die Anschlußkontakte des Bauelementes radial von außen zugänglich sind, wobei die Aufnahmekäfige bei Drehung des Rades nacheinander folgende Stationen durchlaufen: eine Ladestation, in der der betreffende Aufnahmekäfig von der Vereinzelungsvorrichtung ein Bauelement übernimmt, eine Teststation, in der der betreffende Aufnahmekäfig mit dem darin enthaltenen Bauelement radial gegen den Testadapter bewegt wird, und eine Entladestation, in der das getestete Bauelement aus dem betreffenden Aufnahmekäfig entnommen wird, um den entsprechenden Magazinkanal des Ausgangsmagazins weitergeführt zu werden.

Entscheidend ist hier die Teststation und die Möglichkeit der radialen Verschiebung des Aufnahmekäfigs in dieser Station gegen den Testadapter. Durch diese radiale Verschiebung wird der Verbindungsweg zwischen Bauelement und Testcomputer verkürzt mit der Folge, daß die durch die bisher verwendeten Federfinger gebildeten Leitungsinduktivitäten, -kapazitäten und -widerstände reduziert werden bzw. entfallen. Auf diese Weise wird die angestrebte bessere hochfrequenzmäßige Übertragung der Testsignale gewährleistet.

Die so gestaltete erfindungsgemäße Einreichtung hat darüberhinaus den Vorteil einer höheren Arbeitsgeschwindigkeit als die bisher bekannte Einrichtung.

Ferner gewährleistet die erfindungsgemäße Einrichtung eine schonendere Behandlung der Bauelemente, da das Fallen der Bauelemente im Testkanal sowie das schlagartige Auftreffen in der Teststation entfällt.

Eine bevorzugte Ausführungsform der erfindungsgemäßen Einrichtung kann darin bestehen, daß das Transportrad sechs gleichmäßig über seinen Umfang verteilte Aufnahmekäfige aufweist, derart, daß diese ein regelmäßiges Sechseck bilden, daß bei jedem Stillstand des Transportrades während des intermetierenden Betriebes eine Spitze des Sechseckes oben ist, daß sich dabei einer der beiden oberen Aufnahmekäfige mit schräg verlaufenden Aufnahmekanälen in der Ladestation und der andere in der Entladestation befindet, und daß sich der Aufnahmekäfig, dessen Aufnahmekanal vertikal verläuft und der sich an den in der Ladestation befindlichen Aufnahmekäfig in Umlaufrichtung des Transportrades anschließt, in der Teststation befindet.

Die Konstruktion wird zweckmäßigerweise so gestaltet, daß der sich in der Ladestation befindliche Aufnahmekäfig, dessen Aufnahmekanal -schräg nach unten verläuft, mit einem entsprechenden Vereinzelungskanal der Vereinzelungsvorrichtung fluchtet, derart, daß die Überführung eines Bauelementes von dem Vereinzelungskanal in diesen Aufnahmekäfig durch Rutschen des Bauelementes infolge der Schwerkraft erfolgt.

Analog dazu kann die Konstruktion ferner so gestaltet werden, daß der sich in der Entladestation befindliche Aufnahmekäfig, dessen Aufnahmekanal schräg ansteigend verläuft, mit einem entsprechenden Verteilerkanal einer Verteilervorrichtung fluchtet, die die getesteten Bauelemente dem zugeordneten Magazinkanal des Ausgangsmagazins zuführt, derart, daß die Überführung eines Bauelementes von diesem Aufnahmekäfig in den Verteilerkanal durch Rutschen des Bauelementes infolge der Schwerkraft erfolgt.

Um die Aufnahmekäfige an die Länge der Bauelemente anzupassen, kann jeder Aufnahmekäfig eine in Längsrichtung seines Aufnahmekanales justierbaren Endanschlag aufweisen, gegen das Bauelement in eine Laufrichtung läuft. Um zu gewährleisten, daß ein in einen Aufnahmekäfig eingelaufenes Bauelement beim Drehen des Transportrades aus diesem herausgleitet, wird vorgeschlagen, einen radial in den Aufnahmekanal des Aufnahmekäfigs vorschiebbares Rücklauf-Stop-Element vorzusehen, welches mittels einer Kurvenscheibensteuerung und vorzugsweise mittels Federkraft so steuerbar ist, daß es zumindest in der Lade-und Entladeposition aus dem Aufnahmekanal zurückgezogen wird.

Die äußere Begrenzung des Aufnahmekanales jedes Aufnahmekäfigs kann durch eine sich über den Aufnahmekanal erstreckende schmale Abdeckschiene gebildet sein, an der nur der mittlere Teil des Bauelementes anliegt, während dessen seitliche Anschlußkontakte freiliegen.

Eine andere Weiterbildung der erfindungsgemäßen Einrichtung kann darin bestehen, daß das Transportrad einen mittels eines gesonderten Antriebes betätigbaren Exzentertrieb enthält, mit der sich jeweils in Testposition befindliche Aufnahmekäfig axial nach außen gegen den Testadapter vorschiebbar und wieder in die Ausgangslage zurückziehbar ist.

Wenn es sich bei den Bauelementen um dual-in-line-IC's handelt, so sind diese vorzugsweise in den Magazinkanälen des Eingangsmagazins auf dem Rücken liegend angeordnet. Dies deshalb, weil jeder Magazinkanal von einer schmalen Abdeckschiene abgedeckt ist, die zwischen den sich nach oben erstreckenden Anschlußkontakten der dual-in-line-IC's liegt und damit ein Austreten der IC's aus den Magazinkanälen verhindert. Bei der bisher bekannten Einrichtung sind die in den Testkanal zu der Testposition fallenden IC's so ausgerichtet, daß sie dem Testadapter den Rücken zuwenden. Dies ist ohne Belang, da die Kontaktierung durch die erwähnten Federfinger erfolgt. Da im vorliegenden Fall die Anschlußkontakte der dual-in-line-IC's durch eine entsprechende Andruckbewegung in Kontakt mit den Gegenkontakten des Testadapters gebracht werden sollen, ist es erforderlich, daß die dual-in-line-IC's gewendet werden, derart, daß sie in der Testposition mit ihren Anschlußkontakten gegen den Testadapter gerichtet sind. Dementsprechend besteht ein weiterbildender Vorschlag für die erfindungsgemäße Einrichtung darin, daß die Vereinzelungsvorrichtung so ausgebildet ist, daß sie das Bauelement außerdem um 180° wendet, derart, daß die Anschlußkontakte des Bauelementes nach dem Wenden in die entgegengesetzte Richtung weisen als vor dem Wenden.

Eine Möglichkeit zur Realisierung der vorstehend angegebenen Vereinzelungsvorrichtung kann darin bestehen, daß diese ein drehbares Teil mit zwei in Bezug auf die Achse diametral gegenüberliegenden Vereinzelungskanälen aufweist, und daß die erwähnte Achse schräg von oben nach unten verläuft, so daß die Überführung eines Bauelementes von dem betreffenden Magazinkanal des Eingangsmagazins in den zur Aufnahme bereiten Vereinzelungskanal der Vereinzelungsvorrichtung sowie die Überführung eines Bauelementes von dem zur Abgabe bereiten Vereinzelungskanal in den in Ladeposition befindlichen Aufnahmekäfig des Transportrades durch Ruschen infolge der Schwerkraft erfolgt.

Eine andere die Vereinzelungsvorrichtung betreffende Weiterbildung kann darin bestehen, daß sie eine die Achse bildende feststehende Welle enthält, auf der das die beiden Vereinzelungskanäle enthaltende Drehteil drehbar gelagert ist, daß aus der Welle radial ein Anschlagelement in den zur Aufnahme eines Bauelementes bereiten Vereinzelungskanal vorsteht, daß durch die Welle hindurch in Wellelängsrichtung derart justierbar ist, daß bei Drehung des Drehteiles die Abscherung zwischen dem in den zur Aufnahme bereiten Vereinzelungskanal eingelaufenen Bauelement und dem nächstfolgenden Bauelement erfolgt.

Die Einrichtung arbeitet dann besonders - schnell und präzise, wenn zum Antrieb der Vereinzelungsvorrichtung, des Exzentertriebes und des Transportrades Schrittmotoren verwendet werden.

Ein Ausführungsbeispiel der Erfindung wird nachfolgend anhand der Zeichnungen beschrieben. Es zeigen:

Fig. 1 eine schematisierte Darstellung der Einrichtung;

Fig. 2 eine perspektivische Darstellung eines Teiles des Transportrades mit einem in Testposition befindlichen Aufnahmekäfig.

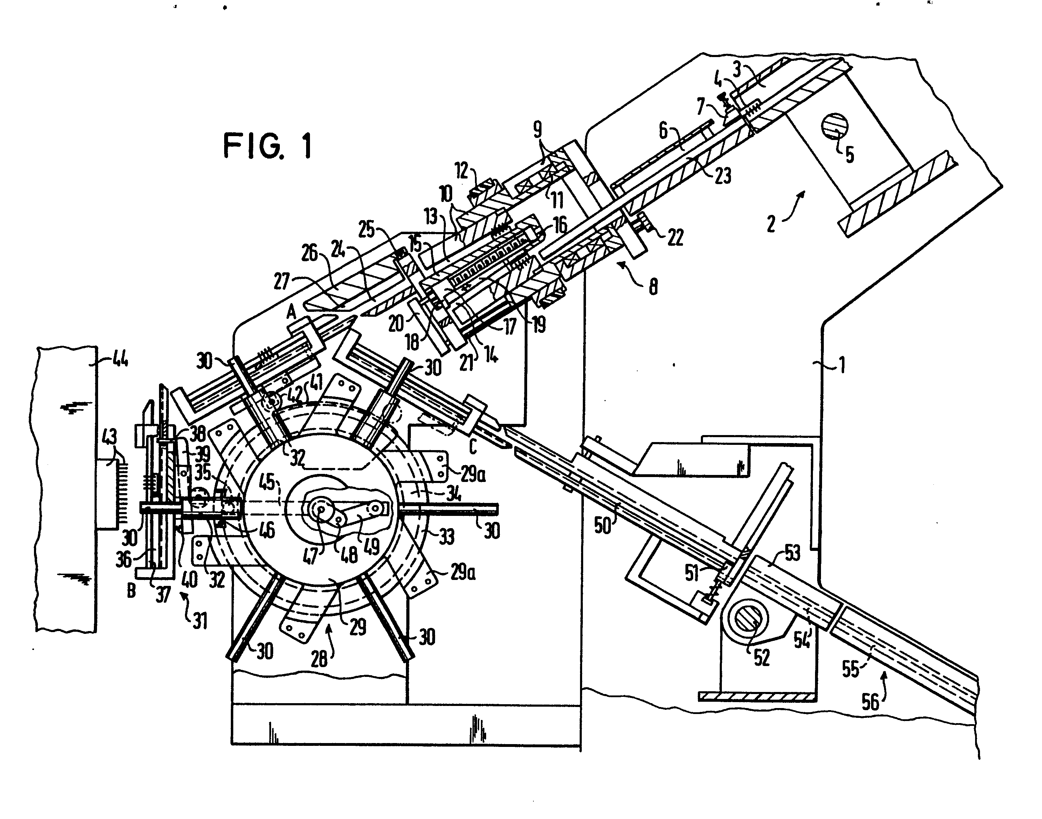

Die in Fig. 1 gezeigte Einrichtung ist in einem Gehäuse 1 untergebracht. Das Gehäuse 1 enthält ein Eingangsmagazin 2, mit einer Vielzahl von parallel nebeneinander liegenden und schräg abwärts gerichteten Magazinkanälen 3, von denen hier im Schnitt nur einer sichtbar ist. In den Magazinkanälen sind die zu testenden Bauelemente 4, bei denen es sich hier im vorliegenden Fall um dual-in-line-IC's handelt, hintereinanderliegend angeordnet. Durch die schräge Anordnung können die Bauelemente 4 infolge der Schwerkraft nacheinander nach unten rutschen. Das Eingangsmagazin 2 ist entlang einer Schlittenführung 5 quer zur Längsrichtung der Magazinkanäle 3 verfahrbar, wodurch jeweils der Ausgang eines der Magazinkanäle in Flucht mit einem sich an das Eingangsmagazin anschließenden Übergangskanal 6 bringbar ist. Am Ausgang des Eingangsmagazins 2 ist ein vorzugsweise elektromagnetisch anhebbares Stopglied 7 angeordnet.

Der Übergangskanal 6 mündet in eine Vereinzelungsvorrichtung 8, die die Bauelemente 4 gleichzeitig wendet, derart, daß die ankommenden mit ihren Anschlußkontakt nach unten weisenden Bauelemente 4 die Vereinzelungsvorrichtung so verlassen, daß die Anschlußkontakte oben liegen. Die Vereinzelunsvorrichtung 8 weist einen feststehenden Rahmen 9 auf, an dem sich ein rotationssymmetrisches Drehteil 10 befindet. Dieses Drehteil 10 läuft auf Lagern 11 am feststehenden Rahmen und wird über einen Riemen 12 angetrieben, der mit einem (nicht dargestellten) Schrittmotor gekoppelt ist. Das Drehteil 10 enthält zwei Vereinzelungskanäle 13, 14, von denen sich der Vereinzelungskanal 13 in der Zeichnung oben und der Vereinzelungskanal 14 unten befindet. Die beiden Vereinzelungskanäle 13, 14 sind schräg nach unten gerichtet und laufen leicht divergierend auseinander. Die Innenbegrenzung der beiden Vereinzelungskanäle 13, 14 wird durch eine feststehende Welle 15 gebildet, die ebenfalls abwärts geneigt ist und sich in Abwärtsrichtung leicht konisch erweitert. In der feststehenden Welle 15 befindet sich eine Schraubspindel 16, auf der ein Anschlagelement 17 verschiebbar gelagert ist. Das Anschlagelement 17 weist eine Anschlagnase 18 auf, die sich durch einen nach unten gerichteten Schlitten 19 in die untere Vereinzelungskammer 14 erstreckt. Die Verschiebbarkeit des Anschlagelementes 17 mit der Anschlagnase 18 ist durch einen Doppelpfeil angedeutet. Die Schraubspindel 16 ist über einen Zahnriemen 20 mit einer parallel zur Schraubspindel 16 verlaufenden und an dem Rahmen 9 drehbar gelagerten Drehspindel 21 verbunden, welche durch Betätigung eines an dem Rahmen 9 befindlichen Drehknopfes 22 drehbar ist. Durch Drehen des Drehknopfes 22 kann also die Anschlagnase 18 in dem Schlitz 19 verschoben und damit die Vereinzelungsvorrichtung 8 an die Länge der Bauelemente 4 angepaßt werden. Die untere Vereinzelungskammer 14 fluchtet mit dem Übergangskanal 6. Eine sich im Übergangskanal 6 befindende Laufschiene 23, deren Breite geringer ist als der Abstand der Anschlußkontakte der Bauelemente 4 erstreckt sich bis unmittelbar vor den unteren Vereinzelungskanal 14. Auf der Laufschiene 23 rutschen die Bauelemente 4 - gewissermaßen auf dem Bauch liegend - abwärts. Die Anschlagnase 18 wird durch Drehen des Drehknopfes 22 so positioniert, daß der Spalt zwischen dem in den unteren Vereinzelungskanal 14 befindlichen Bauelement 4 und dem folgenden Bauelement gerade an der Stelle zu liegen kommt, an der die Laufschiene 23 endet und der untere Vereinzelungskanal 14 beginnt.

Der obere Vereinzelungskanal 13 fluchtet mit einem Anschlußkanal 24, welcher ebenfalls schräg nach unten gerichtet ist. Wenn das Drehteil 10 durch den (nicht dargestellten) Schrittmotor mittels des Riemens 12 um 180° gedreht wird, so wird das in dem unteren Vereinzelungskanal 14 befindliche Bauelement 4 aus der Reihe der aufeinander folgenden Bauelemente abgeschert und nach oben befördert. Der bisher untere Vereinzelungskanal 14 wird dann zu dem oberen Vereinzelungskanal 13 und umgekehrt transportiert. Das Bauelement 4 rutscht dann aus dem oberen Vereinzelungskanal 13 in den Anschlußkanal 24 und von dort aus in der nachfolgend beschriebenen Weise weiter. Zu erwähnen ist noch, daß der Anschlußkanal 24 ein um ein Scharnier 25 hochklappbares Deckteil 26 mit einer oberen Laufschiene 27 aufweist. Die obere Laufschiene 27 ist wiederum so gestaltet, daß ihre Breite geringer ist, als der Abstand der beiden Reihen von Anschlußkontakten der Bauelemente 4, derart, daß die Bauelemente in dem Anschlußkanal 24 auf dem Rücken liegend abwärts rutschen können, wobei sich die Anschlußkontakte der Bauelemente zu beiden Seiten der Laufschiene 27 erstrecken.

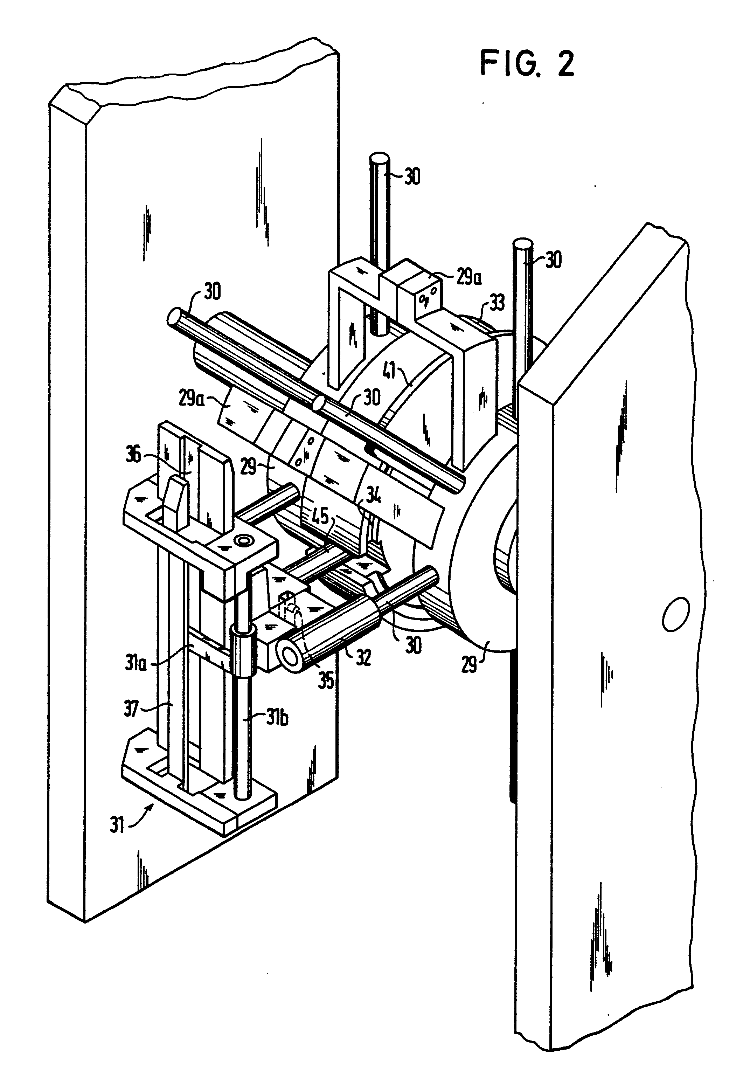

Auf den Anschlußkanal 24 folgt in Laufrichtung der Bauelemente 4 ein Transportrad 28. Dieses besteht aus zwei um eine Achse drehbaren Scheiben 29, die miteinander verbunden sind. In Fig. 1 ist nur eine der beiden Scheiben 29 angedeutet. Die andere Scheibe liegt mit Abstand hinter der sichtbaren Scheibe 29. Dies ist in Fig. 2 erkennbar. Die beiden Scheiben 29 sind durch sechs radial über den Scheibenrand vortretende brückenartige Stege 29a miteinander verbunden. Jede der beiden Scheiben weist ferner zwischen den brückenartigen Stegen sechs sich radial erstreckende Führungszapfen 30 auf. In Fig. 1 sind nur die Führungszapfen der sichtbaren Scheibe 29 erkennbar, in Fig. 2 dagegen die Führungszapfen beider Scheiben 29. Auf jedem Führungszapfenpaar (d.h. auf nebeneinander angeordneten Führungszapfen der beiden Scheiben) sitzt ein Aufnahmekäfig 31 für jeweils ein Bauelement. In Fig. 1 sind drei und in Fig. 2 ist der Übersichtlichkeit halber nur ein Aufnahmekäfig 31 gezeichnet. Jeder Aufnahmekäfig 31 weist zwei Gleitbuchsen 32 auf, die auf den beiden entsprechenden nebeneinanderliegenden Führungszapfen verschiebbar angeordnet sind. In Fig. 1 ist nur auf die vordere auf dem Führungszapfen 30 sitzende Gleitbuchse 32 sichtbar. Die andere Gleitbuchse jedes Aufnahmekäfigs 31 liegt dahinter und ist nicht sichtbar.

Zwischen den beiden drehbaren Scheiben, zu denen die sichtbare Scheibe 29 gehört, ist eine feststehende Scheibe 33 angeordnet, deren Durchmesser im Bereich der brückenartigen Stege 29a kleiner aber zwischen den brückenartigen Stegen 29a größer als der der drehbaren Scheibe ist. Die feststehende Scheibe 33 ist mit einer umlaufenden seitlichen Nute 34 versehen. Jeder Aufnahmekäfig 31 weist an der betreffenden Gleitbuchse 32 einen nach innen gerichteten Nockenzapfen 35 auf, der in der Nute 34 läuft und verhindert, daß der Aufnahmekäfig 31 bis auf eine noch beschriebene Position nach außen verschoben werden kann.

Die drehbaren Scheiben, zu denen die sichtbare Scheibe 29 gehört, sind mit den sechs Aufnahmekäfigen 31 mittels eines (nicht dargestellten) Schrittmotors intermetierend drehbar, derart, daß jeder Aufnahmekäfig 31 nacheinander jede der sechs dargestellten Stellungen durchläuft. Die Aufnahmekäfige 31 bilden praktisch ein regelmäßiges Sechseck, dessen eine Spitze sich oben befindet. Der links oben befindliche Aufnahmekäfig 31 befindet sich in der Ladestation A, in der ein Bauelement aus dem Anschlußkanal 24 in den Aufnahmekäfig 31 einläuft. Der links außen befindliche vertikal ausgerichtete Aufnahmekäfig 31 befindet sich in Teststation B. Der rechts oben befindliche - schräg angeordnete Aufnahmekäfig 31 befindet sich in Entladestation C.

Jeder Aufnahmekäfig 31 weist einen Aufnahmekanal 36 auf, der oben von einer Laufschiene 37 begrenzt ist. Die Laufschiene 37 hat auch hier eine geringere Breite als der Abstand der beiden Reihen von Anschlußkontakten eines Bauelementes, so daß sich die Anschlußkontaktreihen seitlich von der Laufschiene 33 erstrecken können. Ferner weist jeder Aufnahmekäfig 31 einen (in Fig. 1 nicht sichtbaren) Anschlag 31a für das einlaufende Bauelement 4 auf, der in Längsrichtung des Aufnahmekanales 36 mit einer Schraubspindel 31b verstellbar ist und in diesen hineinragt. Ferner ist an jedem Aufnahmekäfig 31 ein Rücklaufstopelement 38 vorgesehen, welches von unten in den Aufnahmekanal 36 eintauchen kann. Das Rücklaufstopelement befindet sich an einer Wippe 39, die um einen Gelenkpunkt 40 schwenkbar ist. Das dem Rücklaufstopelement 38 abgewandte Ende der Wippe 39 steht unter dem Druck einer Druckfeder 40, so daß Rücklaufstopelement 38 normalerweise in den Aufnahmekanal 36 hineinragt und verhindert, daß das darin befindliche Bauelement 4 herausfallen kann. Leidiglich in der Ladestation A und der Entladestation C wird das Rücklaufstopelement 38 aus dem Aufnahmekanal 36 zurückgezogen. Um dies zu erreichen, ist zwischen den beiden feststehenden Scheiben, von denen die Scheibe 29 sichtbar ist, noch ein feststehendes Kurventeil 41 vorgesehen, auf welches eine an der Wippe 39 befindliche Gleitrolle 42 auflaufen kann. Wenn die Gleitrolle 42 auf das Kurventeil 41 aufläuft, so wird die Wippe entgegen der Kraft der Druckfeder 40 geschwenkt, mit der Folge, daß das Rücklaufstopelement 38 aus dem Aufnahmekanal 36 zurückgezogen wird. Auf diese Weise wird ein aus dem Anschlußkanal 24 auslaufendes Bauelement 4 nicht am Einlaufen in den Aufnahmekanal 36 des sich in der Ladestation A befindlichen Aufnahmekäfigs 31 gehindert. Ferner wird ein Bauelement, das in dem in der Entladestation C befindlichen Käfig enthalten ist, nicht an einem Auslaufen gehindert.

In der Teststation C soll der betreffende Aufnahmekäfig 31 radial nach außen bewegt werden, damit die nach außen vorstehenden Anschlußkontakte des sich in seinem Aufnahmekanal 36 befindlichen Bauelementes 4 mit entsprechenden Gegenkontakten eines Testadapters 43 in Kontakt treten können. Der Testadapter 43 ist an einen Testcomputer 44 angeschlossen. Um die radiale Verschiebung zu gewährleisten, ist an der linken Seite der feststehenden Scheibe 33 ein Stück dieser Scheibe als verschiebbarer Stempel 46 ausgebildet. Dieser verschiebbare Stempel enthält demnach auch ein Stück der Nute 34. Die Verschiebung des Stempels 46 erfolgt jeweils dann, wenn sich der entsprechende Aufnahmekäfig 31 in der Teststation B befindet. Das bedeutet, daß sich der Nocken 35 dieses Aufnahmekäfigs 31 in dem zu dem verschiebbaren Stempel 46 gehörenden Nutenstück befindet. Der verschiebbare Stempel 46 ist mit einer Exzenterstange 45 verbunden, die zu einem in der feststehenden Scheibe 33 angeordneten Exzentermechanismus gehört. Zu diesem Exzentermechanismus gehört ferner ein um eine Welle 47 drehbarer Kurbelzapfen 48, der gelenkig mit einer Kurbelstange 49 verbunden ist, die ihrerseits gelenkig mit der Exzenterstange 45 verbunden ist. Die Welle 47 ist (in Fig. 1 nicht sichtbar) exzentrisch in der Antriebswelle für die beiden drehbaren Scheiben gelagert, von denen die vordere Scheibe 29 sichtbar ist. Die Antriebswelle 47 für den Exzentermechanismus wird wiederum durch einen (nicht dargestellten) Schrittmotor gedreht. Wenn die Exzenterstange 45 zurückgezogen wird, so nimmt der den Nutenabschnitt aufweisende Stempel 46, in dem sich der Nocken 35 befindet, den in der Teststation B befindlichen Aufnahmekäfig 31 wieder mit zurück.

Die getesteten Bauelemente 4 gelangen - schließlich mit dem Aufnahmekäfig 31, in dem sie enthalten sind, in die Entladestation C, wo sie in einen Auslaufkanal 50 einlaufen. Am Ende des Auslaufkanales 50 befindet sich ein Stopelement 51, das elektromagnetisch betätigbar ist.

An der Auslaufkanal 50 schließt sich ein auf einer Welle 52 verfahrbares Sortiershuttle 53 an, das ebenfalls einen Aufnahmekanal 54 für jeweils ein Bauelement aufweist. Das Sortiershuttle befördert das in ihm enthaltene Bauelement zu dem Eingang des entsprechend dem Testergebnis ausgewählten Magazinkanals 55 eines feststehenden Ausgangsmagazins 56.

## Ansprüche

1. Einrichtung zum Testen und Sortieren von elektronischen Bauelementen, insbesondere von dual-in-line-IC's, mit einem Eingangsmagazin, das mindestens einen Magazinkanal für die zu testenden Bauelemente aufweist, mit einer Vereinzelungsvorrichtung für die dem Magazinkanal nacheinander zu entnehmenden Bauelemente, mit einer Teststation, in welcher die zu prüfenden Bauelemente in Kontakt mit einem Testadapter gebracht werden, dem von einem Testcomputer Testsignale zugeführt werden, mit einem Ausgangsmagazin, das mindestens einen Magazinkanal für die als gut befundenen Bauelemente und mindestens eine Magazinakal für die als schlecht oder fehlerhaft befundenen Bauelemente aufweist, gekennzeichnet durch
ein intermittierend drehbares Transportrad (28, 29), das an mindestens drei Stellen seines Umfangs einen Aufnahmekäfig (31) mit einem etwa tangential verlaufenden Aufnahmekanal (36) für ein Bauelement (4) aufweist, der so ausgebildet ist, daß die Anschlußkontakte des Bauelementes (4) radial von außen zugänglich sind, wobei die Aufnahmekäfige (31) bei Drehung des Rades (28, 29) nacheinander folgende Stationen durchlaufen: eine Ladestation (A), in der der betreffende Aufnahmekäfig (31) von der Vereinzelungsvorrichtung (8) ein Bauelement (4) übernimmt, eine Teststation (B), in der der betreffende Aufnahmekäfig (31) mit dem darin enthaltenen Bauelement (4) radial gegen den Testadapter (43) bewegt wird, und eine Entladestation (C), in der das getestete Bauelement (4) aus dem betreffenden Aufnahmekäfig (31) entnommen wird, um an den entsprechenden Magazinkanal (5) des Ausgangsmagazins (56) weitergeführt zu werden.

2. Einrichtung nach Anspruch 1,
dadurch gekennzeichnet,
daß das Transportrad (28, 29) sechs gleichmäßig über seinen Umfang verteilte Aufnahmekäfige (31) aufweist, derart, daß diese ein regelmäßiges Sechseck bilden, daß bei jedem Stillstand des Transportrades (28, 29) während des intermittierenden Betriebes eine Spitze des Sechseckes oben ist, daß sich dabei einer der beiden oberen Aufnahmekäfige (31) mit schräg verlaufenden Aufnahmekanälen (36) in der Ladestation (A) und der andere in der Entladestation (C) befindet, und daß sich der Aufnahmekäfig (31), dessen Aufnahmekanal vertikal verläuft und der sich an den in der Ladestation (A) befindlichen Aufnahmekäfig (36) in Umlaufrichtung des Transportrades anschließt, in der Teststation (B) befindet.

3. Einrichtung nach Anspruch 2,
dadurch gekennzeichnet,
daß der sich in der Ladestation (A) befindliche Aufnahmekäfig (31), dessen Aufnahmekanal (36) - schräg nach unten verläuft, mit einem entsprechenden Vereinzelungskanal (13) der Vereinzelungsvorrichtung (8) fluchtet, derart, daß die Überführung eines Bauelementes (4) von dem Vereinzelungskanal in diesen Aufnahmekäfig (31) durch Rutschen des Bauelementes (4) infolge der Schwerkraft erfolgt.

4. Einrichtung nach Anspruch 2 oder 3,
dadurch gekennzeichnet,
daß der sich in der Entladestation (C) befindliche Aufnahmekäfig (31), dessen Aufnahmekanal (36) - schräg ansteigend verläuft, mit einem entsprechenden Verteilerkanal (54) einer Verteilervorrichtung (53) fluchtet, die die getesteten Bauelemente (4) dem zugeordneten Magazinkanal (55) des Ausgangsmagazins (56) zuführt, derart, daß die Überführung eines Bauelementes (4) von diesem Aufnahmekäfig (31) in den Verteilerkanal (54) durch Rutschen des Bauelementes (4) infolge der Schwerkraft erfolgt.

5. Einrichtung nach einem der vorhergehenden Ansprüche,
daß jeder Aufnahmekäfig (31) einen in Längsrichtung eines Aufnahmekanals (36) justierbaren Endanschlag aufweist, gegen den das Bauelement (4) in Einlaufrichtung läuft, und ferner ein radial in den Aufnahmekanal (36) des Aufnahmekäfigs (31) verschiebbares Rücklaufstop-Element (38) für das in dem Aufnahmekäfig (31) befindliche Bauelement (4), und daß eine Kurvenscheibensteuerung (31 bis 42) für das Rücklaufstop-Element (38) vorgesehen ist, durch welche ein Zurückziehen des Rücklaufstop-Elementes (38) aus dem Aufnahmekanal (36) des betreffenden Aufnahmekäfigs (31) zumindest in der Lade-und Entladestation (A und C) gewährleistet wird.

6. Einrichtung nach einem der vorhergehenden Ansprüche,
dadurch gekennzeichnet,
daß an der Außenseite jedes Aufnahmekäfigs (31) eine seinen Aufnahmekanal (36) überdeckende - schmale Abdeckschiene (37) vorgesehen ist, an der nur der mittlere Teil des Bauelementes (4) anliegt, während dessen seitliche Anschlußkontakte freiliegen.

7. Einrichtung nach einem der vorhergehenden Ansprüche,
dadurch gekennzeichnet,
daß das Transportrad (28, 29) einen mittels eines gesonderten Antriebes betätigbaren Exzentertrieb (45 bis 49) enthält, mit dem der sich jeweils in Testposition befindliche Aufnahmekäfig (31) axial nach außen gegen den Testadapter (43) verschiebbar und wieder in die Ausgangslage zurückziehbar ist.

8. Einrichtung nach einem der vorhergehenden Ansprüche,
dadurch gekennzeichnet,
daß das Transportrad (28) zwei parallel und im Abstand zueinander angeordnete und miteinander verbundene drehbar gelagerte Radscheiben (29) aufweist, die an ihren Umfang durch mehrere radial vorspringende brückenartige Stege (29a) miteinander verbunden ist, daß zwischen den brückenartigen Stegen (29a) von jeder der beiden Radscheiben eine gleiche Zahl von radialen Führungszapfen (30) ausgehen, die paarweise einander zugeordnet sind, daß jeder Aufnahmekäfig (31) mit zwei Gleitbuchsen (32) versehen ist, die radial verschiebbar auf einem Führungszapfen-Paar (30) sitzen, daß zwischen den drehbar gelagerten Radscheiben einer feststehenden Scheibe (33) angeordnet ist, die an mindestens einer Seite nächst ihrem Rand eine umlaufende kreisringförmige Nut (34) und sich zwischen die Gleitbuchsen (32) der Aufnahmekäfige (31) erstreckt, daß an jedem Aufnahemkäfig (31) ein in der Nut (34) der feststehenden Scheibe (33) geführter Nocken (35) vorgesehen ist, daß ein den entsprechenden Nutenabschnitt umfassender Randbereich der feststehenden Scheibe (33) als von letzter lösbarer und radial verschiebbarer Stempel (46) ausbildet ist, und daß in der feststehenden Scheibe ein Exzentermechanismus (45 bis 49) vorgesehen ist, mittels welchem der Stempel (46) mit dem in Teststation befindlichen Aufnahmekäfig (31) radial nach außen verschiebbar und wieder zurückziehbar ist.

9. Einrichtung nach Anspruch 8,
dadurch gekennzeichnet,
daß sich eine mit dem Exzentermechanismus (45 bis 49) verbundene Antriebswelle (47) konzentrisch durch wenigstens eine der beiden drehbaren Radscheiben (29) hindurch erstreckt.

10. Einrichtung nach Anspruch 5 und 8 oder 9,
dadurch gekennzeichnet,
daß das Rücklaufstop-Element (38) an einem Ende einer Wippe sitzt, die an der der feststehenden Scheibe (33) zugewandten Seite des Aufnahmekäfigs (31) sitzt und durch eine Feder (40) derart vorgespannt ist, daß das Rücklaufsotp-Element in den Aufnahmekanal (36) des Aufnahmekäfigs (31) gedrückt wird, und daß mit der feststehenden Scheibe (33) ein Kurventeil (41) verbunden ist, auf dem ein Nockenelement (42) läuft, das mit den dem Rücklaufstop-Element (38) abgewandten Ende der Wippe (39) verbunden ist.

11. Einrichtung nach einem der vorhergehenden Ansprüche,
dadurch gekennzeichnet,
daß die Vereinzelungsvorrichtung (8) ausgebildet ist, daß sie das Bauelement (4) außerdem um 180° wendet, derart, daß die die Anschlußkontakte das Bauelement (4) nach dem Wenden in die entgegengesetzte Richtung weisen als vor dem Wenden.

12. Einrichtung nach Anspruch 11,
dadurch gekennzeichnet,
daß die Vereinzelungsvorrichtung (8) ein um eine Achse drehbares Drehteil (10) mit zwei in Bezug auf die Achse diametral gegenüberliegenden Vereinzelungskanälen (13, 14) aufweist, und daß die erwähnte Achse schräg von oben nach unten verläuft, so daß die Überführung eines Bauelementes (4) von dem betreffenden Magazinkanal (3) des Eingangsmagazins in den zur Aufnahme bereiten Vereinzelungskanal (14) der Vereinzelungsvorrichtung (8) sowie die Überführung eines Bauelementes (4) von dem zur Abgabe bereiten Vereinzelungskanal (13) in den in der Ladestation (A) befindlichen Aufnahmekäfig (31) des Transportrades (28, 29) durch Rutschen infolge der Schwerkraft erfolgt.

13. Einrichtung nach Anspruch 12,
dadurch gekennzeichnet,
daß die Vereinzelungsvorrichtung (8) eine die Achse bildende feststehende Welle (15) enthält, auf der das die beiden Vereinzelungsknäle (13, 14) enthaltende Drehteil (10) drehbar gelagert ist, daß aus der Welle radial ein Anschlagelement (17, 18) in den zur Aufnahme eines Bauelementes (4) bereiten Vereinzelungskanal (14) vorsteht, das durch die Welle (15) hindurch in Wellenlängsrichtung derart justierbar ist, daß bei Drehung des Drehteiles (10) die Abscherung zwischen dem in den zur Aufnahme bereiten Vereinzelungskanal (14) eingelaufenen Bauelement (4) und dem nächst folgenden Bauelement (4) erfolgt.

14. Einrichtung nach Anspruch 12 oder 13,
dadurch gekennzeichnet,
daß der Antrieb für die Vereinzelungsvorrichtung (8) von einem Schrittmotor gebildet ist.

15. Einrichtung nach Anspruch 7,
dadurch gekennzeichnet,
daß der Antrieb für den Exzentrtrieb (45 bis 49) für den in Teststation (B) befindlichen Aufnahmekäfig (31) des Tranportrades (28, 29) von einem Schrittmotor gebildet ist.

16. Einrichtung nach einem der vorhergehenden Ansprüche,
dadurch gekennzeichnet,
daß der Antrieb für das Transportrad (28, 29) von einem Schrittmotor gebildet ist.

FIG. 1

0 269 889

FIG. 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-3 716 134 (CAMPBELL) * Anspruch 1; Figuren 1-3, 16, 19 * | 1,2 | B 07 C 5/344 B 07 C 5/36 |
| A | --- | 3-16 | |
| A | US-A-3 750 878 (ATCHLEY et al.) * Anspruch 1; Figuren 1, 2, 7, 10 * --- | 1-16 | |
| A | EP-A-0 144 715 (UEBERREITER) * Anspruch 1; Figuren 1-9 * & DE - A - 3 340 183 (Kat. D) ----- | | |

| RECHERCHIERTE SACHGEBIETE (Int. Cl.4) |
|---|
| B 07 C 5/344 B 07 C 5/36 G 01 R 31/28 |

Der vorliegende Recherchenbericht wurde für alle Patentansprüche erstellt

| Recherchenort | Abschlußdatum der Recherche | Prüfer |
|---|---|---|
| BERLIN | 05-02-1988 | LEMMERICH J |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
·······································································
& : Mitglied der gleichen Patentfamilie, übereinstimmendes
    Dokument

EPO FORM 1503 03.82 (P0403)